# EUROPEAN PATENT APPLICATION

(11) **EP 3 067 919 A1**
(43) Date of publication of application: **14.09.2016**
(21) Application number: 15158703.7
(22) Date of filing: 11.03.2015
(51) Int. Cl.: H01L 21/3065

(54) **Method for forming vertical structures in a semiconductor target layer**

(71) Applicant: IMEC VZW, 3001 Leuven (BE)
(72) Inventor: Milenin, Alexey, 3001 Leuven (BE); Witters, Liesbeth, 3001 Leuven (BE)
(74) Representative: DenK iP

(57) **Abstract**

Method for forming vertical structures in a semiconductor target layer comprising at least one element selected from the group consisting of Si and Ge, the said method comprising the steps of a) Providing a patterned hard mask layer on the semiconductor target layer; b) Dry plasma etching of the semiconductor target layer through said patterned hard mask, thereby forming said vertical structures. The said dry plasma etching comprises at least the steps of II. Halogen, with or without 02, based plasma etching or Fluorocarbon based plasma etching, III. Fluorocarbon based plasma etching when the step II. is a halogen based plasma etching or halogen based plasma etching when the step II. is a fluorocarbon based plasma etching, when the halogen based plasma etching is performed without 02, a step of 02 and/or N2 based passivation, step I. is performed before the plasma etching step II.

## Description

### 1. Field of the invention

The present invention relates to the field of semiconductor processing. More specifically, it relates to a method for forming vertical (e.g. fin) structures in a semiconductor target layer for the making of semiconductor devices, to the use of the semiconductor target layer obtained by the said method in semiconductor devices and to semiconductor layer having vertical structures with low depth loading profile and without wiggling.

### 2. Background of the Art

Scaling of feature sizes in Complementary Metal Oxide Semiconductor (CMOS) technology in order to achieve performance enhancement, has led to the introduction of new transistor designs such as Fin-type Field Effect Transistors (FinFETs) or tri-gate FETs and to the introduction of new materials. While in their early introduction these new designs still used Si as the channel material, the need for engineering this Si channel and the need for using alternative channel materials that have high mobility and low effective mass has increased over the years especially advanced technology nodes such as sub-10 nm technology.

For patterning of the fins in such advanced nodes in order to realize the manufacture of FinFETs, substrates having top layers made of Ge, SiGe or Si is used. These top layers can be strained or relaxed with the strain type depending on whether an n-channel FET or a p-channel FET is to be produced. Patterning of the fins into such substrates requires obtaining small critical dimension (CD), by small critical dimension we intend to mean critical dimension lower than 10 nm, straight profiles and reduced or absence of depth loading.. Fin patterning having vertical structures with low depth loading profile and without wiggling leads to FinFETs having a better performance, higher yield and good reproducibility.

Small CD features can be provided by Self-Aligned Multiple Patterning (SAMP) techniques such as Self-Aligned Double Patterning (SADP) or Self-Aligned Quadrupole Patterning (SAQP) or using Directed Self-Assembly (DSA).

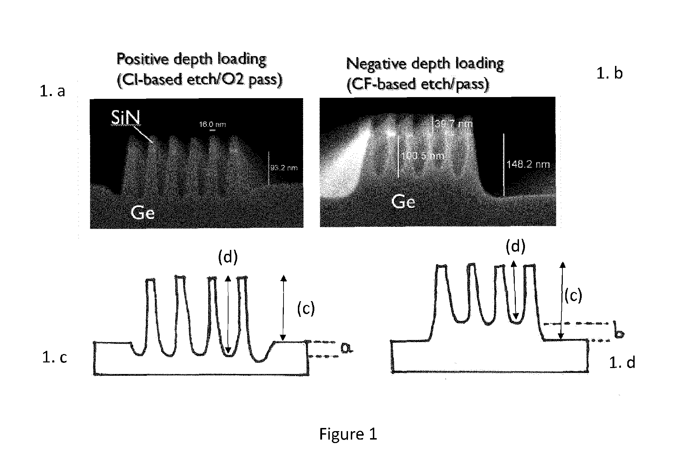

However, obtaining straight profiles without wiggling and reduced or absence of depth loading still remains to be a challenge in the art. The expression "depth loading" is understood to mean, after that the etching step b) has been performed, the absolute value of the difference between the average etching depth away from the pattern (see distance (c) in figure 1) and the average etching depth between vertical structures of the pattern (see distance (d) in figure 1).

The said "depth loading" represents the variation of the etching front between the masked part and the unmasked part of the semiconductor target layer after etching. In the patterned target layer obtained after the dry plasma etching, the depth loading corresponds to the absolute value of the difference between 1) the height of the vertical structure measured from the patterned target layer away from the pattern and 2) the height of the vertical structures measured from the valley between the vertical structures.

### 3. Problems to be solved

It is an aim of the invention to overcome the disadvantages of the prior art.

More precisely, an aim set by the present invention, in at least one embodiment, is to provide a method for forming vertical structures in a semiconductor target layer on a substrate, the said method enabling the formation of vertical structures with reduced depth loading or without the said depth loading. As used herein, the expression "vertical structures" is understood to denote vertical structures having the morphology of wires, fin, or sheets. More in particular, the vertical structures of the present invention can be nanowires, nanofins or nanosheets. The width (i.e. the thickness) of each of the vertical structures is preferably lower than 50 nm, more preferably from 1 to 30 nm and even more preferably from 2 to 20 nm and most preferably from 2 to 9 nm. In the case of nanowires, both lateral dimensions (width and length) are equal and the vertical dimension (height) of the nanowires can be for instance from 15 to 300 nm, preferably from 30 to 250 nm. In the case of (nano)fins, The length is longer than the width of the fins. The length of the fin can for instance be from 15 to 100 nm, preferably from 20 to 60 nm. The height of the fin can be for instance from 15 to 300 nm, preferably 30 to 250 nm. When the fins according to embodiments of the present invention have a thickness (i.e. a width) of from 2 to 9 nm, they may be called nanosheets. When the thickness of the structure varies along its height, the thickness is the average thickness along said height.

An aim set of the present invention, in at least one embodiment, is to provide a method for forming vertical structures in a semiconductor target layer on a substrate, the said method enabling the formation of vertical structures having straight profiles in the absence of or with reduced depth loading.

Another aim set by the present invention, in at least one embodiment, is to provide a semiconductor layer having vertical structures with low depth loading profile, the said vertical structures having straight profiles.

An aim set of the present invention, in at least one embodiment, is to provide a use of the said semiconductor target layer obtained by the method according to the invention in semiconductor devices.

### 4. Invention disclosure

The present invention is directed to a method for forming vertical structures in a semiconductor target layer comprising at least one element selected from the group consisting of Si and Ge, the said method comprising the steps of:
a) Providing a patterned hard mask layer on the semiconductor target layer,
b) Dry plasma etching of the semiconductor target layer through said patterned hard mask layer, thereby forming said vertical structures,
   wherein the dry plasma etching comprises at least the steps of:
   II. A halogen, with or without O2, based plasma etching or a fluorocarbon based plasma etching,
   III. A fluorocarbon based plasma etching when the step III. is a halogen, with or without O2, based plasma etching or halogen, with or without O2, based plasma etching when the step III. is a fluorocarbon based plasma etching.
When the halogen based plasma etching is performed without O2, a step of O2 and /or N2 based passivation I. is performed before the first plasma etching step II.

The inventors have surprisingly found that the control of the depth loading can be obtained in a more efficient way by using a dry etching comprising successively an halogen, with or without O2, based plasma etching or a fluorocarbon based plasma etching and a fluorocarbon based plasma etching when a halogen, with or without O2, based plasma etching is previously used or halogen, with or without O2, based plasma etching when a fluorocarbon based plasma etching is previously used, a O2 or N2 passivation step being performed step I. before the plasma etching step II. when the plasma etching of step II. is an halogen based etching without O2.

In any embodiments of the present invention, step II. typically precedes step III. and step II. preferably directly precede step III.

In any embodiment of the present invention where a step I. is present, step I typically is typically performed before step II. and step I preferably directly precede step II.

The method according to the invention offers means to equalize the etching front independently from the type of vertical structures (e.g. fins). These vertical structures can form a dense pattern of vertical structures, a semi-dense pattern of vertical structures or an sparse pattern of vertical structures (composed of isolated vertical structures).

A pattern of vertical structures will be considered dense if it comprises at least two neighbouring vertical structures such that the ratio between, on one hand, the average of their thicknesses and, on another hand, the average inter-distance between neighbouring vertical structures, is above or equal to 0.5. The term inter-distance refers to the distance between the (lateral and vertical) middle of a first vertical structure and the (lateral and vertical) middle of the second neighbouring vertical structure.

Similarly, a pattern of vertical structures will be considered sparse if this ratio is below or equal to 0.1 and will be considered semi-dense if this ratio is comprised between 0.1 and 0.5, the said values being excluded.

The pattern of vertical structures formed by the method according to some embodiments of the present invention preferably comprises at least two neighbouring vertical structures such that the ratio between, on one hand, the average of their thicknesses and, on another hand, the average inter-distance between neighbouring vertical structures, is above or equal to 0.1, preferably above or equal to 0.15, more preferably above or equal to 0.2, yet more preferably above or equal 0.3 and most preferably above or equal to 0.5. It is for semi-dense and dense patterns that the problem of depth loading is typically the most pronounced and it is therefore also for such patterns that the present invention is most useful.

The pattern of vertical structures formed by the method according to some embodiments of the present invention preferably comprises at least two neighbouring and parallel vertical structures. This applies in particular to patterns of fins and nanosheets.

Preferably, all vertical structures of a pattern have the same dimensions.

Preferably, all vertical structures of a pattern are equidistant. The inter-distance between any two neighbouring vertical structures corresponds then to the pitch of the pattern.

Preferably, all vertical structures of a pattern have the same dimensions, are parallel and are equidistant.

The step II of the dry plasma etching is a halogen, with or without O2, based plasma etching, or a fluorocarbon based plasma etching.

The term "target" of the expression "semiconductor target layer" means that the target layer is the semiconductor layer on which the method, according to the invention, is performed

As used herein and unless provided otherwise, the terms "halogen, with or without O2, based plasma etching" refer to a plasma etching of the semiconductor target layer performed in an atmosphere containing at least 50% in weight of halogen, preferably at least 75% of halogen, the said atmosphere containing or not O2. The said halogen being pure (e.g. Cl2) or being a halogen hydride (e.g. HBr), preferably Cl2. The term "pure" means that the halogen compound contains only halogen atoms.

As used herein and unless provided otherwise, the terms "fluorocarbon based plasma etching" refer to a plasma etching of the semiconductor target layer performed in an atmosphere containing at least 30% in weight of fluorocarbon, preferably 50% of fluorocarbon, the said fluorocarbon being the major compound constituting the atmosphere. The term 'fluorocarbon" refers to chemical compound containing carbon and fluoride atoms, the said fluorocarbon may be present in the form of a single compound or in a mixture of several compounds. Preferably the fluorocarbon is selected from the group consisting of CF4, CHF3, CH2F2, CH3F, C4F8, C4F6 and the mixture of at least two thereof, preferably selected from the group consisting of CHF3, CH2F2 and the mixture thereof, more preferably the fluorocarbon is CH2F2. It is well known by the one skilled in the art that a fluorocarbon plasma etching has also a passivation effect. The passivation effect of the fluorocarbon plasma etching is linked to the amount of carbon atom in the fluorocarbon. To control the passivation effect, it is possible to add additional gas in the gas mixture like O2, SF6 or NF3. The use of gas containing fluoride without carbon like SF6 or NF3 simultaneously with a given fluorocarbon leads to a better control of the plasma etching by controlling the ratio Carbone atoms/Fluor atoms in the total gas mixture.

The step III of the dry plasma etching is a fluorocarbon based plasma etching when the second step (II) of the dry plasma etching is a halogen, with or without O2, based plasma etching or halogen, with or without O2, based plasma etching when the second step (II) of the dry plasma etching is a fluorocarbon based plasma etching.

A step I which is passivation step under O2 and/or N2, preferably under O2 or N2, more preferably under O2, is performed when the halogen plasma etching is performed without O2. The terms "passivation step under O2 and/or N2" mean that the passivation step is performed in an atmosphere comprising, preferably consisting of, O2, N2 or the mixture thereof.

The advantage of using O2 is linked to the formation of thin oxide layer of Ge and Si on the sidewalls, the said thin oxide are more easy to be dissolved with a standard wet HF cleaning step that is applied after vertical structure etch, the HF solutions used during the standard wet HF cleaning step are solution having a concentration of 1.5% in volume of HF, while nitrides may require some other treatment, for example treatment in hot phosphoric acid.

The passivation step permits also to avoid an undercut that may happen in a Ge layer if a halogen, with or without O2, based plasma etching is used directly on a non-passivated Ge layer.

In a preferred embodiment, the method according to the invention is such that the dry plasma etching comprises the steps of:
I. O2 and/or N2 based passivation
II. Halogen, with or without O2, based plasma etching or fluorocarbon based plasma etching
III. Fluorocarbon based plasma etching when the step II. is a halogen, with or without O2, based plasma etching or halogen, with or without O2, plasma etching when the step II. is a fluorocarbon based plasma etching.

The inventors have surprisingly found that the control of the depth loading and the formation of vertical structures having straight profiles can be obtained in a more efficient way by using a dry plasma etching comprising successively a O2 and/or N2 based passivation, an halogen, with or without O2, based plasma etching or a fluorocarbon based plasma etching and a fluorocarbon based plasma etching when a halogen, with or without, based plasma etching is previously used or halogen, with or without O2, based plasma etching when a fluorocarbon based plasma etching is previously used. The method according to the invention offers means to equalize the etching front independently from the type of structures and thus reducing the depth loading, the said structures forming a dense pattern, a sparse pattern or semi-dense pattern and to control the profile of the vertical structures.

The semiconductor target layer comprises at least one element selected from the group consisting of Si and Ge. More specifically the semiconductor target layer is a layer of SixGe1-x with o ≤ x ≤ 1, the said layer could be a strained layer of SixGe1-x or a strained relaxed buffer layer of SixGe1-x.

When the semiconductor target layer is a Si layer (x = 1), the said layer being used as channel material in a semiconductor device, it has to be strained in order to provide a high mobility. The said strain could be a tensile strain or a compression strain. The tensile strain is preferred for N-type Metal-Oxide-Semiconductor (NMOS). The said tensile strain can be obtained by the use of a SixGe1-x with 0 < x < 1 strained relaxed buffer layer underneath the Si layer or by tensile source/drain stressor such as Si1-yCy with 0 < y < 1 or SiC. The compressive strain is preferred for P-type Metal-Oxide-Semiconductor (PMOS). The said compressive strain can be obtained by compressive SixGe1-x with 0< x < 1 source/drain stressors.

When the semiconductor target layer is a Ge or a SixGe1-x layer with 0< x < 1, the said layer being used as channel material in a semiconductor device, the said layer can be among other:
- A Germanium layer of a Germanium on insulator (GeOI), in this case no Shallow Trench Isolation (STI) are needed due to the mesa-isolation of the GeOI after the dry etching cycle.
- A thick relaxed Ge layer which has been grown onto a Si substrate, the term "thick" refers to a layer having a thickness higher than 100 nm, the term "relaxed" refer to a layer without strain. The thickness of the said Ge layer permits to overcome the defects originating from the lattice mismatch between Si and Ge and to obtain a defect free Ge layer. A Shallow Trench Isolation (STI) method is performed on the relaxed Ge layer, the said STI method comprising the patterning of the relaxed Ge layer into a set of protrusions, for instance extending from the substrate, and providing a silicon oxide in between adjacent protrusions to electrically isolate them from each other, the protrusions and the silicon oxide isolation abutting on a common planar surface. The shallow Trench Isolation method is performed after the relaxed Ge layer deposition.
- A strained Ge layer, the said Ge layer being grown on a relaxed SixGe1-x with 0 < x < 1 buffer layer which has been grown onto a silicon substrate. A Shallow Trench Isolation (STI) method is performed on the strained Ge layer and on the relaxed SixGe1-x buffer layer, the said STI method comprising the patterning of the strained Ge layer and the relaxed SixGe1-x buffer layer into a set of protusions, for instance extending from the substrate, and providing a silicon oxide in between adjacent protrusions to electrically isolate them from each other, the protrusions and the silicon oxide isolation abutting on a common planar surface. The shallow Trench Isolation method is performed after the strained Ge layer and the SixGe1-x buffer layer deposition.

- A strained SixGe1-x layer with 0 < x < 1, the said layer being grown onto a silicon substrate. A Shallow Trench Isolation (STI) method is performed on the strained SixGe1-x layer, the said STI method comprising the patterning of the strained SixGe1-x buffer layer into a set of protrusions, for instance extending from the substrate, and providing a silicon oxide in between adjacent protrusions to electrically isolate them from each other, the protrusions and the silicon oxide isolation abutting on a common planar surface. The shallow Trench Isolation method is performed after the strained SixGe1-x layer deposition.
- A Si layer of a Si substrate. A Shallow Trench Isolation (STI) method is performed on the Si layer, the said STI method comprising the patterning of the Si layer into a set of protrusions, for instance extending from the substrate, and providing a silicon oxide in between adjacent protrusions to electrically isolate them from each other, the protrusions and the silicon oxide isolation abutting on a common planar surface. The shallow Trench Isolation is performed on the Si substrate prior the Si layer deposition.

The semiconductor target layer may be deposited on a substrate selected from the group consisting of quartz, sapphire, silicon, silicon on insulator (SiOI), germanium on insulator (GeOI).

Before the dry plasma etching a patterned hard mask layer is provided on the semiconductor target layer, said patterned hard mask comprises opening which length and width correspond to the length and width of the vertical structures to be etched in the semiconductor target layer. The term "correspond" means that the dimensions of the openings in the hard mask layer are such that after etching the whished dimensions of the vertical structures are obtained. The said patterned hard mask layer may comprise a silicon nitride (SixNy) patterned layer, more preferably a Si3N4 patterned layer (easily used in Chemical Mechanical Polishing (CMP) as stopping layer). The said patterned layer mask may be applied by Self-Aligned Multiple Patterning (SAMP) techniques such as Self-Aligned Double Patterning (SADP) or Self-Aligned Quadrupole Patterning (SAQP) or by using Directed Self-Assembly (DSA). In a preferred embodiment the said patterned hard mask layer comprises, starting from the semiconductor target layer, a first layer which is a silicon nitride patterned layer, more preferably a Si3N4 patterned layer, and a second layer which is a silicon oxide (SixOy), preferably a SiO2, patterned layer having the same pattern that the one of the first silicon nitride layer. More particularly the thickness of the said double layer is in the same magnitude than the height of the vertical structure obtained after the plasma etching, preferably the thickness of the second layer is greater or equal to 50% of the total thickness of the patterned hard mask layer, more preferably greater of equal to 75% of the total thickness of the patterned hard mask layer. For example, the double layer may comprises a first layer of Si3N4 having a thickness in the range from 40 to 50 nm and a second layer for SiO2 having a thickness in the range from 40 to 70 nm.

According to a preferred embodiment, the halogen, with or without O2, based plasma etching, preferably the Cl2, with or without O2, based plasma etching comprises at least two steps: a strike plasma etching and a main plasma etching. The strike plasma etching having a time duration lower than the main plasma etching. The strike plasma etching is typically performed at a lower power than the main plasma etching. The said two steps plasma etching leading a better preservation of the tools used to perform the halogen, with or without, based plasma etching.

According to preferred embodiment, the halogen, with or without O2, based plasma etching includes a bias pulsing. The said bias pulsing leads to the decrease of the loading depth. The terms "bias pulsing" mean regular interruption in the RF power supply of the generator connected to the electrostatic chuck (ESC), the regular interruptions typically have frequencies in the range of 100 Hz, while RF is 13.56 MHz.

In a particular embodiment duty cycle is used, the said Duty cycle is such that during a percentage of the time the RF is on during single period of pulsing.

According to a preferred embodiment, the dry plasma etching comprises at least the steps of:
I. O2 based passivation,
II. Fluorocarbon based plasma etching,
III. Halogen, with or without O2, based plasma etching.

According to a preferred embodiment, the dry plasma etching is performed as a dry plasma etching cycle, said dry plasma etching cycle being reproduced at least two times, preferably at last 3 times. The etching step with or without passivation being reproduced until the expected vertical structures are obtained. The time of required for each step of the dry plasma etching is lower or equal to 5 seconds.

According to a preferred embodiment, the passivation step is performed at least under a pressure comprises in the range from 17 mTorr to 23 mTorr, preferably from 18mTorr to 22 mTorr, a TCP power comprises in the range from 561 to 759W, preferably from 594 to 726W, a N2 and/or O2 gas flow, preferably a O2 gas flow, from 170 to 230 sccm, preferably from 180 to 220 sccm, at a ESC temperature comprises in the range from 59 °C to 81 °C, preferably from 63°C to 77°C, the duration of the said passivation step being comprised between 1 s to 5 s, preferably between 2 to 3 s.

According to a preferred embodiment, the halogen, with or without O2, based plasma etching, preferably the Cl2, with or without O2, based plasma etching, more preferably the Cl2 without O2 based plasma etching, is performed at least under a TCP power source comprises from 425 W to 575 W, preferably from 450 W to 550W, a bias pulsing voltage from 467 V to 633 V DC, preferably from 485 V to 605 V DC, voltage of 550 V DC, a pulse comprised from 34 to 46%, preferably from 36 to 44%, a frequency comprised from 85Hz to 115Hz, preferably from 90Hz to 110Hz, a halogen gas flow, preferably a Cl2 gas flow comprised from 50 sccm to 115 sccm, preferably from 50 sccm to 110 sccm, a pressure from 2.55 mTorr to 3.45 mTorr, preferably from 2.7 mTorr to 3.3 mTorr, a ESC temperature comprises in the range from 59 °C to 81 °C, preferably from 63°C to 77°C, the duration of the said passivation step being comprised between 1 s to 5 s. Preferably said halogen, with or without O2, based plasma etching, preferably Cl2 with or without O2 based plasma etching, more preferably the Cl2 without O2 based plasma etching is performed in two step, a first strike plasma etching of 1 to 3 seconds, preferably 2, seconds followed by a main plasma etching of 2 to 4 seconds, preferably 3 seconds. During the first strike plasma etching the bias is a voltage comprised from 340 V to 460 V, preferably from 360 V to 440 V and a halogen gas flow, preferably a Cl2 gas flow comprised from 42 sccm to 58 sccm, preferably from 45 sccm to 55 sccm.

According to a preferred embodiment, the fluorocarbon based plasma etching is performed at least under a pressure comprised from 2.1 mTorr to 2.9 mTorr, preferably from 2.2mTorr to 2.8 mTorr, a TCP power comprised from 280 W to 380 W, preferably from 297 W to 363 W, a bias from 85 V DC to 115 V Dc, preferably from 90 V DC to 110 V DC, a He gas flow from 25 sccm to 35 sccm, preferably from 27 sccm to 33 sccm, a N2 gas flow from 29 sccm to 41 sccm, preferably from 31 sccm to 39 sccm, a SF6 gas flow from 20 sccm to 26 sccm, preferably from 21 sccm to 25 sccm, a CH2F2 gas flow from 42 sccm to 58 sccm, preferably from 45 sccm to 55 sccm, a ESC temperature comprised from 34 °C to 46 °C, preferably from 36°C to 44°C. The duration of said fluorocarbon based plasma etching step being comprised between 1 s to 5 s, preferably between 2 to 3 s.

According to a preferred embodiment, the dry plasma etching is a dry plasma etching cycle repeated at least n times with n ≥ 1, preferably n is 1 or 2. More preferably the dry plasma etching cycle is performed from 2 to 5 times.

According to a preferred embodiment, the dry etching is performed in an Inductively Coupled Plasma (ICP) reactor.

According to a preferred embodiment, the method of the invention is performed on semiconductor target layer consisting of Si, Ge or SixGe1-x with 0 < x < 1.

Another aspect of the invention relates to semiconductor layer for microelectronic device comprising at least two adjacent vertical structures and having a depth loading lower or equal to 15 nm in absolute value, preferably lower or equal to 10 nm. More particularly, the said at least two adjacent vertical structures have a straight profile.

The terms "straight profiles" is understood to mean that the fine structures, in other words the vertical structures, don't present wiggling.

According to a preferred embodiment of the preceding one, the semiconductor layer for microelectronic device according is a strained germanium layer.

Use of a semiconductor target layer having vertical structures obtained according to the method of the invention in a semiconductor device.

The method according to the invention will now be illustrated on the basis of the following figures. The figures show in a non-restrictive manner some substrate structures. These figures are purely for illustration purposes and do not constitute a representation of structures to scale.
Figure 1 shows cross sections of fin structures obtained after prior art dry plasma etching.
Figure 2 represents the main steps of the dry plasma etching method according to the invention.
Figure 3 shows a preferred embodiment of the dry plasma etching method according to the invention.
Figure 4 illustrates a cross sectional view of the evolution of the semiconductor target layer during the dry plasma etching according to an embodiment of the method of the invention.
Figure 5 illustrates a cross section of a vertical structure obtained after dry plasma etching according to the method of the invention.

Figure 1 exemplified vertical structures obtained according to the prior art dry plasma etching methods. The cross section of vertical structures obtained after a halogen based plasma etching are presented on figure 1a, it appears that a depth loading is present after the etching. The said halogen based plasma etching is performed in a ICP apparatus under a pressure of 3 mTorr, a source power of 500W, a bias power of 550V DC (pulsing duty cycle 40%, 100Hz), a Transformer Coupled Capacitive Tuning to tune uniformity of 1.2 center and gas flow of 100 sccm of Cl2, 50 sccm of Ar at a ESC temperature of 70°C. Figure 1b presents a typical cross section of vertical structures obtained after a fluorocarbon based plasma etching, a depth loading appears after the said etching. The said fluorocarbon based etching is performed in a ICP apparatus under a pressure of 2.5 mTorr, a power source of 330W, a bias power of 100V DC, a Transformer Coupled Capacitive Tuning to tune uniformity of 1.2, center, the term "center" means that it is around a center point, the power being distributed equally between the segment of the TCP coil. The range of TCCT is from 0.1 to 2.5 and it is not a linear response, 1.2 being an average value and gas flows of 30 sccm of He, 35 sccm of N2, 23 sccm of SF6, 50 sccm of CH2F2 at a ESC temperature of 40°C. Fig.1c is a schematic representation of a target semiconductor layer after a halogen based plasma etching according to the prior art method, the said target semiconductor layer presents after etching a positive depth loading represented by the distance "a" equal to (d) - (c), Fig. 1d is a schematic representation of a target semiconductor layer after a halogen based plasma etching according to the prior art method, the said target semiconductor layer presents after etching a negative depth loading represented by the distance "b" equal to (c) - (d).

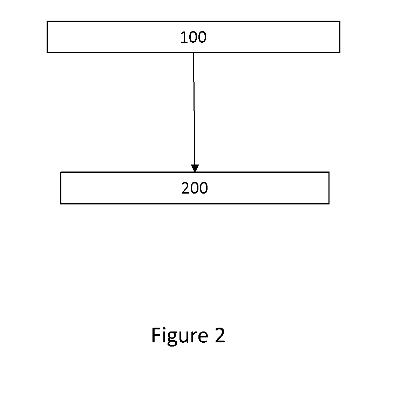

Figure 2 presents the main steps of the method according to the invention. The said main steps comprise a step of providing a patterned hard mask layer on the semiconductor target layer (100) followed by the step of forming vertical structures in the semiconductor target layer by dry plasma etching through said patterned hard mask layer (200). The patterned hard mask comprises a layer of silicon nitride, preferably Si3N4.

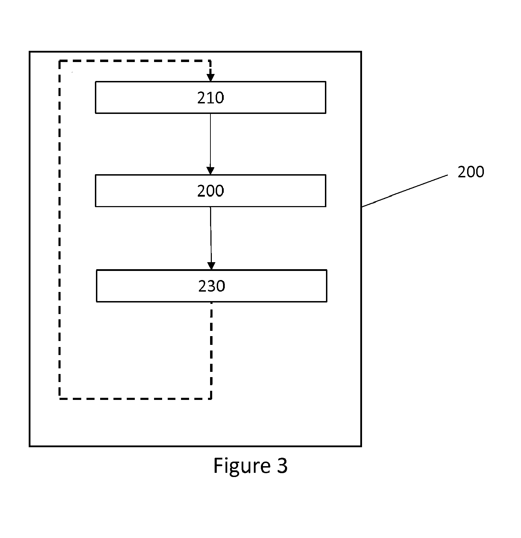

Figure 3 presents a preferred embodiment of the dry etching method according to the invention. The said dry plasma etching (200) comprises successively a passivation step (210), a fluorocarbon based plasma etching (220) and a halogen, with or without O2, based plasma etching (230). The passivation step is an O2 and /or N2 based passivation. The said passivation is followed by a fluorocarbon based plasma etching. The fluorocarbon used may be present in the form of a single compound or in a mixture of several compounds. Preferably the fluorocarbon is selected from the group consisting of CF4, CHF3, CH2F2, CH3F, C4F8, C4F6 and the mixture thereof, preferably selected from the group consisting of CHF3, CH2F2 and the mixture thereof, more preferably the fluorocarbon is CH2F2. A halogen based etching is performed after the fluorocarbon based etching. The said halogen being pure (i.e. Cl2) or a halogen hydride (i.e. HBr), preferably Cl2. The dry plasma etching is performed as a dry plasma etching cycle. The dry etching plasma cycle is reproduced until the expected vertical structures are obtained. The time of required for each step of the dry plasma etching is lower or equal to 5 seconds. Preferably, the halogen, with or without O2, based plasma etching step comprises at least two additional steps a "strike" plasma etching and a "main" plasma etching. The term "strike" means that the strike plasma etching has a time duration lower than the "main" plasma etching. The strike plasma etching is typically performed at a lower power (typically at a lower voltage) than the main plasma etching.

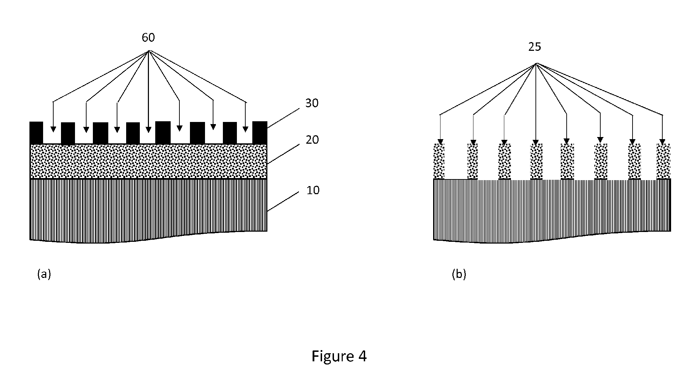

Figure 4 illustrates a cross sectional view of the evolution of the semiconductor target layer during the plasma etching according to an embodiment of the method of the invention. Figure 4 (a) represents the semiconductor target layer (20) on a substrate (10) before the dry plasma etching. The said semiconductor target layer (20) is covered by a patterned hard mask (30), the said mask having a plurality of trenches (60). Figure 4 (b) represents the semiconductor target layer after the dry plasma etching, the said semiconductor target layer having fin structures (25).

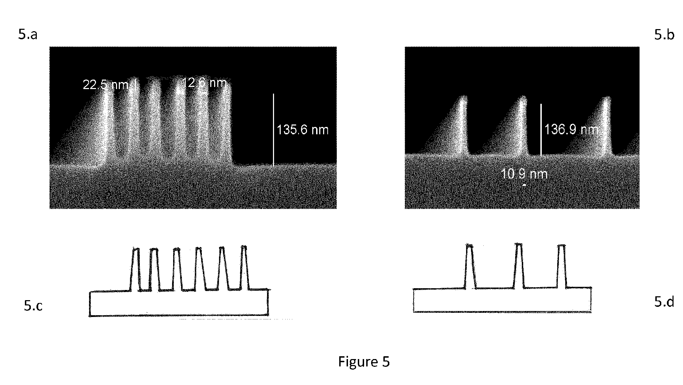

Figure 5 illustrates a cross section of a vertical structure obtained after dry plasma etching according to the method of the invention. We clearly note a reduction of the depth loading.
An example of dry plasma etching conditions is given in the table I hereafter. The semiconductor target layer is a strain germanium layer, the patterned hard mask layer comprise a Si3N4 layer.

**Table I: Example of dry plasma etching method in a Inductive coupling plasma apparatus according to the invention:**

| Step | Conditions |
|---|---|
| Passivation | Pressure: 20.0 mTorr, Power source: 660W, Transformer coupled capacitive tuning to tune uniformity: 0.9, edge, Gas flows: 200 sccm O2, Temperature: 70°C, time: 3 seconds |
| Fluorocarbon based plasma,etching | Pressure: 2.5 mTorr, Power source: 330W, Bias voltage: 100 V DC; Transformer coupled capacitive tuning to tune uniformity: 1.2, center, Gas flows: 30 sccm He, 35 sccm N2, 23 sccm SF6, 50 sccm CH2F2, Temperature: 40°C, time: 5 seconds |
| Halogen without O2 based plasma etching | A strike etching of 2 seconds followed by a main etching of 3 seconds, the other etching condition being the same in the two halogen etching steps Pressure: 3.0 mTorr, Power source: 500W, Bias voltage: 550 V DC (puls 40%, 100 Hz); Transformer coupled capacitive tuning to tune uniformity: 1.2, center, Gas flows: 100 sccm Cl2, 50 sccm Ar, Temperature: 70°C, time: 5 seconds |

The said dry plasma etching was performed 3 times.

## Claims

1. Method for forming vertical structures (25) in a semiconductor target layer (20) comprising at least one element selected from the group consisting of Si and Ge, the said method comprising the steps of:
a) Providing (100) a patterned hard mask layer (30) on the semiconductor target layer (20),
b) Dry plasma etching of the semiconductor target layer (200) through said patterned hard mask layer (30), thereby forming said vertical structures (25),
**characterized in that** the dry plasma etching (200) comprises at least the steps of:
II. Halogen, with or without O2, based plasma etching or Fluorocarbon based plasma etching (220),
III. Fluorocarbon based plasma etching when the step II. is a halogen based plasma etching or halogen based plasma etching when the step II. (220) is a fluorocarbon based plasma etching (230),
when the halogen based plasma etching is performed without O2, a step of O2 and/or N2 based passivation, step I. (210) is performed before the plasma etching step II.

2. Method according to claim 1, wherein the dry plasma etching (200) comprises at least the steps of:
I. O2 and/or N2 based passivation (210),
II. Halogen, with or without O2, based plasma etching or Fluorocarbon based plasma etching (220),
III. Fluorocarbon based plasma etching when the step II. is a halogen, with or without O2, based plasma etching or halogen, with or without O2, based plasma etching when the step II. is a fluorocarbon based plasma etching (230).

3. Method according to anyone of the preceding claims, wherein the step II (220) is a fluorocarbon based plasma etching.

4. Method according to any one of the preceding claims, wherein the step I. (210) is an O2 based passivation.

5. Method according to any one of the preceding claims, wherein the halogen, with or without O2, based plasma etching is a Cl2, with or without O2, based plasma etching.

6. Method according to claim 5, wherein the Cl2, with or without O2, based plasma etching comprises at least two additional steps a strike plasma etching and a main plasma etching.

7. Method according to any one of the preceding claims, wherein the halogen, with or without O2, based plasma etching includes a bias pulsing.

8. Method according to claims 2, wherein the dry plasma etching comprises at least the steps of:
I. O2 based passivation (210),
II. Fluorocarbon based plasma etching (220),
III. Halogen, with or without O2, based plasma etching (230).

9. Method according to any one of the preceding claims, wherein said dry plasma etching is repeated at least one times.

10. Method according to any one of the preceding claims, wherein the dry plasma etching is performed in an Inductively Coupled Plasma (ICP) reactor.

11. Method according to any one of the preceding claims, wherein the semiconductor target layer (20) consists of Si, Ge or SixGe1-x with 0 < x < 1.

12. Semiconductor target layer (20) obtained according any one of the methods of claims 1 to 11.

13. Semiconductor layer for microelectronic device comprising at least two neighbouring vertical structures such that the ratio between, on one hand, the average of their thicknesses and, on another hand, the average inter-distance between neighbouring vertical structures, is above or equal to 0.15 and wherein said at least two neighbouring vertical structures have a depth loading lower or equal to 15 nm in absolute value.

14. Semiconductor layer for microelectronic device according to claim 13, wherein said layer is a strained germanium layer (20).

15. Use of a semiconductor target layer obtained according to claim 12 in a semiconductor device.
